# EUROPÄISCHE PATENTSCHRIFT

(11) **EP 3 281 507 B1**
(45) Veröffentlichungstag und Bekanntmachung des Hinweises auf die Patenterteilung: **02.09.2020**
(21) Anmeldenummer: 16738381.9
(22) Anmeldetag: 06.07.2016
(51) Int. Cl.: H05K 7/20, H01L 23/36, H01L 23/373, H02M 7/00, H02M 7/493, H02M 1/00, H02M 1/32, H01L 23/00

(54) **PHASENMODUL FÜR EINEN STROMRICHTER**
PHASE MODULE FOR A POWER CONVERTER
MODULATEUR DE PHASE POUR CONVERTISSEUR DE COURANT

(30) Priorität: 14.08.2015 EP 15181114
(43) Veröffentlichungstag der Anmeldung: 14.02.2018
(73) Patentinhaber: Siemens Aktiengesellschaft, 80333 München (DE)
(72) Erfinder: LORZ, Roland, 91341 Röttenbach (DE); SOMMER, Rainer, 91336 Heroldsbach (DE)
(86) Internationale Anmeldenummer: PCT/EP2016/065913
(87) Internationale Veröffentlichungsnummer: WO 2017/029020

(56) Entgegenhaltungen:
- EP-A2- 0 569 221
- EP-A2- 1 387 609
- DE-A1- 4 143 346
- US-A1- 2006 284 211
- US-A1- 2012 014 059
- US-A1- 2012 218 710

## Beschreibung

Die Erfindung betrifft einen Stromrichter aufweisend mindestens ein Schaltelement und einen Kühlkörper. Die Erfindung betrifft weiter ein Verfahren zur Herstellung eines solchen Stromrichters.

Stromrichter werden eingesetzt, um elektrische Maschinen oder elektrische Netze mit elektrischer Energie zu versorgen. Mit Hilfe des Stromrichters lässt sich die Maschine steuern und regeln. Darüber hinaus kommen Stromrichter für die verlustarme Übertragung von Energie zur Anwendung. Ein weiteres Anwendungsgebiet für Stromrichter stellen Kompensatoren dar. Mit ihnen lassen sich Blindleistungen und/oder Stromoberschwingungen kompensieren, d.h. beseitigen, oder gezielt in ein Netz einspeisen.

Für den Aufbau eines Stromrichters werden die erforderlichen Schaltelemente, die Halbleiter aufweisen, auf Kühlkörper montiert. Die Schaltelemente sind dabei als Module unterschiedlicher Leistungsfähigkeit am Markt verfügbar. Für einen guten Wärmeübergang, d.h. für eine gute Kühlung des Schaltelements, wird vor der Montage auf die Kontaktfläche Wärmeleitpaste aufgetragen, um einen möglichst guten Wärmeübergang durch Beseitigung von Lufteinschlüssen zu erzielen.

Dabei werden oftmals mehrere Schaltelemente auf einen Kühlkörper montiert. Der Kühlkörper, in diesem Fall vom Gewicht her deutlich größer als das Gewicht der einzelnen Schaltmodule, hat neben der Funktion der Kühlung gleichzeitig auch die Funktion, die Module im Stromrichter zu halten bzw. zu befestigen. Kräfte, wie Gewichtskraft oder durch Bewegung verursachte Kräfte wie beispielsweise durch Erschütterungen, werden durch den Kühlkörper aufgenommen.

Zur Herstellung von Stromrichtern mit unterschiedlicher Leistung werden Module mit unterschiedlicher Leistungsfähigkeit verbaut. Diese unterscheiden sich in ihrer Baugröße und teilweise in der Bauform, so dass auch unterschiedliche Kühlkörper für unterschiedliche Leistungsklassen verwendet werden. Ebenso ist es üblich, mehrere Module parallel anzuordnen. Nachteilig hierbei ist jedoch, dass aufgrund von Streuungen in den Produkteigenschaften sich der Strom nicht gleichmäßig auf die Module aufteilt. Dadurch werden die Module von ihrer Leistungsfähigkeit nicht optimal ausgenutzt. Dies führt zu hohen Kosten mit nur geringer Steigerung der Leistungsfähigkeit. Durch eine Parallelschaltung von Stromrichtern lassen sich zwar unterschiedliche Leistungsbereiche abdecken, allerdings sind diese mit hohen Kosten verbunden.

Aus der US 2012/0014059 A1 ist ein Leistungsmodul bekannt. Das Leistungsmodul umfasst einen ersten Leistungschip und einen zweiten Leistungschip, von denen jeder mindestens zwei Elektroden aufweist. Das Leistungsmodul wird ineinem Stromrichter angewendet. Der Stromrichter hat dabei eine Leistungsdichte von mehr als 15W/Kubikzoll und einen maximalen Wirkungsgrad von mehr als 92% oder der Stromrichter hat eine Leistungsdichte von mehr als 20W/Kubikzoll oder einem maximalen Wirkungsgrad von mehr als 93%. Mindestens einer der Leistungschips arbeitet bei einer Frequenz von mehr als 25 kHz.

Der Erfindung liegt die Aufgabe zugrunde, einen Stromrichter zu verbessern.

Diese Aufgabe wird durch einen Stromrichter mit den Merkmalen des Anspruchs 1 gelöst. Ferner wird die Aufgabe durch ein Verfahren zur Herstellung eines solchen Stromrichters gelöst, wobei zur Herstellung einer Verbindung zwischen dem Schaltelement und dem Kühlkörper das Schaltelement auf den Kühlkörper gelötet, gesintert oder geklebt wird.

Weitere vorteilhafte Ausgestaltungen der Erfindung sind in den abhängigen Ansprüchen angegeben.

Der Erfindung liegt die Erkenntnis zugrunde, dass sich ein Phasenmodul dadurch verbessern lässt, dass das Schaltelement nichtlösbar mit dem Kühlkörper verbunden ist. Eine nichtlösbare Verbindung stellt beispielsweise das Löten, Sintern oder Kleben dar. Es ist zwar technisch möglich, diese Verbindung zu lösen, allerdings sind weitere, teilweise sogar recht aufwendige, Schritte erforderlich, um die Verbindung wieder herzustellen. Teilweise kann das Lösen der Verbindung zu dauerhaftem Schaden an Kühlkörper und/oder Schaltelement führen.

Als besonders vorteilhaft hat es sich erwiesen, dass durch diese nichtlösbare Verbindung ein besonders guter Wärmeübergang von Schaltelement zu Kühlkörper herstellen lässt. Zufriedenstellende Kühlergebnisse lassen sich somit bereits mit relativ kleinen und damit leichten Kühlkörpern herstellen.

Dabei können sämtliche Arten an Kühlkörpern genutzt werden. Insbesondere die Verwendung der Kühlmedien Luft oder Flüssigkeit, wie beispielsweise Wasser, haben sich als vorteilhaft erwiesen. Ebenso hat sich eine Kühlung als vorteilhaft erwiesen, bei der der Kühlkörper Heatpipes aufweist. Für die Flüssigkeitskühlung ist noch die weitere Schnittstelle für den Kühlmittelkreislauf zu beachten. Dieser kann über den Trägerrahmen bzw. der Tragplatte realisiert werden. Alternativ können die Halbbrückenmodule direkt zu Stacks konfiguriert werden (verschrauben, verspannen, verpressen wie z.B. im Wasserleitungsbau).

Als besonders vorteilhaft hat es sich erwiesen, für das Schaltelement oder die Schaltelemente eines Phasenmoduls genau einen Kühlkörper vorzusehen. Anders ausgedrückt werden mit dem Kühlkörper jeweils nur das Schaltelement oder die Schaltelemente eines Phasenmoduls verbunden. Durch den guten Wärmeübergang und der Aufgabe, nur ein Phasenmodul zu entwärmen, ist der Kühlkörper besonders klein und leicht ausführbar. Das Verhältnis von Gewicht des Kühlkörpers des Phasenmoduls zum Gesamtgewicht des Phasenmoduls ist relativ gering. Das Gewicht des Kühlkörpers beträgt dabei oftmals weniger als 50% des Gewichts des gesamten Phasenmoduls inklusive Kühlkörper.

Als besonders vorteilhaft hat es sich erwiesen, die nichtlösbare Verbindung von Schaltelement und Kühlkörper für Schaltelemente mit einer Sperrspannung im Bereich von 1200V und 1700V vorzusehen. Es hat sich gezeigt, dass die Vorteile des guten Wärmeübergangs und der damit verbundenen kleinen und leichten Kühlkörper die nachfolgenden Nachteile überwiegen. Bei den Nachteilen ist zu nennen, dass aufgrund der im Vergleich zu Anwendungen außerhalb der Leistungselektronik wie beispielsweise die Mikroelektronik mit einem erhöhten Ausschuss in der Herstellung der nichtlösbaren Verbindung zu rechnen ist. Bei Anwendungen außerhalb der Leistungselektronik ist die Lötfläche sehr klein. Dadurch kann eine gleichmäßige Erhitzung an der Verbindungsfläche sichergestellt werden, so dass die Verbindung leicht herstellbar ist.

Im Bereich der Leistungselektronik, insbesondere bei Leistungshalbleitern mit einer Sperrspannung im Bereich von 1200V und 1700V sowie darüber hinaus ist die Kontaktfläche groß. Hier muss sichergestellt werden, dass diese Fläche gleichmäßig erwärmt bzw. erhitzt wird. Da dies schwierig zu erzielen und ggf. zu überwachen ist, ist mit einem erhöhten Ausschuss bei der Herstellung der nichtlösbaren Verbindung zu rechnen. Es muss beim Löten oder Sintern von Schaltelementen mit einer Sperrspannung im Bereich von 1200V bis 1700V eine gleichmäßige Erwärmung über die Kontaktfläche sowohl des Schaltelements als auch des Kühlkörpers erfolgen. Bereits geringe Abweichungen können zu mechanischen Spannungen in der Verbindung führen, welche zu einem Verlust der Haftwirkung in der Verbindung führt oder zumindest die Wärmeleitung zwischen Schaltelement und Kühlkörper derart verschlechtert, dass diese in Bezug auf Wärmeleitfähigkeit keine Vorteile mehr gegenüber einer aus dem Stand der Technik bekannten Schraubverbindung zwischen Schaltelement und Kühlkörper liefert. Eine im Herstellungsprozess nicht optimale Verbindung zwischen Schaltelement und Kühlkörper ist durch die nichtlösbare Eigenschaft nicht oder zumindest nur mit einem hohen technischen Aufwand korrigierbar, der die Wirtschaftlichkeit dieser Phasenmodule in Frage stellt.

Somit ist die Herstellung der nichtlösbaren Verbindung für Leistungshalbleiter insbesondere mit einer Sperrspannung im Bereich von 1200V bis 1700V und darüber hinaus nur schwierig fehlerfrei herstellbar.

Die nichtlösbare Verbindung hat neben der guten Wärmeleitfähigkeit, die für einen Betrieb bei hoher Leistung oder hohen Strömen wichtig ist, darüber hinaus den Vorteil, einer höheren Wechsellastfestigkeit. Eine schwankende Belastung, auch als Wechsellast bezeichnet, führt bei Schraubverbinden, die heutzutage zwischen Kühlkörper und Schaltelement mit einer Sperrspannung im Bereich von 1200V und 1700V zur Anwendung kommen, zu einer stark unterschiedlichen Ausdehnung aufgrund unterschiedlicher Temperaturkoeffizienten der Materialien von Kühlkörper und Schaltelement. Diese werden durch die Wärmeleitpaste ausgeglichen. Die Wärmeleitpaste wird dadurch mechanisch beansprucht, da diese einem Walgprozess unterliegt. Diese führt zum einen zu einer Verdrängung der Wärmeleitpaste aus der Kontaktfläche. Darüber hinaus führt dies zu einer Verringerung der Lebensdauer, die sich in einer teilweise sogar deutlichen Reduktion der Wärmeleitfähigkeit äußert.

Betrachtungen zur Wechsellastfestigkeit sind bei Anwendungen außerhalb der Leistungselektronik nicht von Interesse. Da schwankende Belastungen dort nicht zu großen Temperaturdifferenzen führen, haben diese keinen beschränkenden Einfluss auf die Lebensdauer der Halbleiter und werden dort daher nicht bei der Auslegung und Herstellung von Halbleitern berücksichtigt.

Darüber hinaus ist bei dem Phasenmodul der Kühlkörper derart klein und leicht, dass er eine geringe thermische Kapazität aufweist. Diese wiederum bewirkt eine deutliche geringere Temperaturdifferenz zwischen Schaltelement und Kühlkörper. Daraus resultiert eine noch geringere Empfindlichkeit gegenüber einer schwankenden Belastung und führt zu einer hohen Wechsellastfähigkeit des Phasenmoduls.

Als besonders vorteilhaft hat es sich erwiesen, Schaltelemente mit einer Sperrspannung im Bereich 1200V bis 1700V und niedriger Stromtragfähigkeit für das Phasenmodul mit nichtlösbarer Verbindung zu verwenden. Diese niedrige Stromtragfähigkeit liegt im Bereich von 100A bis 200A. Hier ist das Verhältnis von Gewicht Kühlkörper zum Gesamtgewicht des Phasenmoduls besonders günstig, da nur relativ wenig Verlustleistung im Schaltelement entsteht, die gekühlt werden muss. Mit diesen Phasenmodulen lassen sich auf einfache Weise dreiphasige Stromrichter, insbesondere 2-Punkt-Stromrichter, zusammenstellen, die eine Leistung im Bereich von 70kW bis 100kW liegen. Pro Phase ergibt sich somit eine Leistung von etwa 20kW bis 35kW. Dabei kann in einer vorteilhaften Ausgestaltung eine Phase durch ein Phasenmodul realisiert werden, wenn dieses Phasenmodul als Halbbrücke mit zwei Schaltelementen aufgebaut ist.

Durch die einzelnen Phasenmodule, beispielsweise drei Phasenmodule bei einem dreiphasigen Stromrichter, ist man in der Anordnung dieser Phasenmodule flexibel, da die einzelnen Schaltelemente nicht alle auf einem Kühlkörper angeordnet sind. Die einzelnen Phasenmodule können nahezu unabhängig voneinander im Stromrichter angeordnet werden. Somit können beispielsweise Luftkanäle für die Kühlluft besonders klein dimensioniert werden. Der Platzbedarf der Phasenmodule ist damit entsprechend gering. Durch das geringere Gewicht ist auch die Montage innerhalb des Stromrichters deutlich einfacher als bei großen und damit schweren Kühlkörpern, da auf aufwendige Tragkonstruktionen verzichtet werden kann.

Es hat sich darüber hinaus als vorteilhaft erwiesen, Snubber Kondensatoren für die schnelle Kommutierung, insbesondere für Wide Band Gap Halbleiter, in das Phasenmodul zu integrieren. Die Integration der zusätzlichen Bauelemente ist vorzugsweise auf dem gleichen Substrat wie das Schaltelement und ohne gesonderte Bauelementegehäuse (auf Chip Ebene) ausgeführt. Ebenso ist es vorteilhaft, die gleichen Kontaktierungstechnologien wie für die Leistungshalbleiter zu verwenden.

Eine Erhöhung der Leistungsfähigkeit einer Phase des Stromrichters und damit eine Erhöhung der Leistungsfähigkeit des gesamten Stromrichters können auf einfache Weise durch die Parallelschaltung mehrerer Phasenmodule erfolgen. So kann beispielsweise bei dem oben erwähnten dreiphasigen 2-Punkt-Stromrichter durch die Parallelschaltung zweier Phasenmodule in den Phasen eine Leistung des Stromrichters von insgesamt 140kW bis 200kW erreicht werden. Somit steht mit dem Phasenmodul ein hochintegriertes, variantenarmes Modulkonzept im Hinblick auf die Modularität, Parallelschaltbarkeit und Granularität zur Verfügung.

Durch die Parallelschaltung von Phasenmodulen können Stromrichter im Leistungsbereich von 70kW bis 1MW auf einfache Weise durch die Verwendung einer entsprechenden Anzahl an Phasenmodule auf einfache Weise modular zusammengestellt werden.

Das Pha-senmodul weist mindestens einen elektrischen Anschluss auf, wobei das Phasenmodul mittels des elektrischen Anschlusses befestigbar ist. Durch den modularen und skalierbaren Ansatz bildet das Phasenmodul inklusive Kühlkörper einen sehr kompakten Aufbau. Dieser Aufbau eignet sich aufgrund von geringer Größe und niedrigem Gewicht für eine Befestigung mittels des elektrischen Anschlusses. Hierfür eignet sich in besonders vorteilhafter Weise eine Busbar Verschienung (Stromschiene), die üblicherweise bei Schaltelementen mit Sperrspannungen im Bereich 1200V bis 1700V und darüber hinaus, zur niederinduktiven Verbindung mit den Kondensatoren des Zwischenkreises vorgesehen ist. Der Querschnitt dieser Stromschiene ergibt sich aus der Strombelastbarkeit und damit aus der Leistungsfähigkeit des Phasenmoduls bzw. des aus dem Phasenmodul aufgebauten Stromrichters. Es hat sich gezeigt, dass gerade durch die beschriebene Gewichtsreduktion bei dem Kühlkörper aufgrund der nichtlösbaren Verbindung von Schaltelement und Kühlkörper die Kräfte für die Befestigung im Stromrichter derart niedrig sind, dass diese von der Stromschiene und dem entsprechenden Befestigungselement zwischen Stromschiene und elektrischem Anschluss des Phasenmoduls, wie beispielsweise einer Schraube oder Klemmfeder, aufgenommen werden kann. Auf eine zusätzliche mechanische Fixierung der Phasenmodule kann damit verzichtet werden. Falls auf eine zusätzlich mechanische Fixierung/Befestigung nicht verzichtet werden soll oder diese gewünscht bzw. vorgeschrieben ist, kann diese zumindest derart klein ausgelegt werden, dass sie nur noch einen geringen Anteil der Kraft zur Befestigung des Phasenmoduls aufbringen muss. Der Anteil der dann durch die zusätzliche mechanische Befestigung aufzunehmenden Kraft ist geringer als die über die elektrischen Anschlüsse aufgenommene Kraft. Damit vereinfacht sich der mechanische Aufbau des Stromrichters durch die Verwendung der Phasenmodule erheblich. Dies führt zu einer weiteren Gewichtsreduktion sowie einer Kostenreduktion des mit den Phasenmodulen aufgebauten Stromrichters.

Alternativ oder ergänzend kann das Phasenmodul auch in eine Halterung, auch als Halteplatte bezeichnet, in Form einer Schablone gesteckt werden. Aufgrund des geringen Gewichts der Phasenmodule und der darin befindlichen Kühlkörper ist nur eine geringe Kraft zum Halten/Fixieren in der Halterung erforderlich. Diese kann beispielsweise durch eine Klemmvorrichtung aufgebracht werden.

Bei einer vorteilhaften Ausgestaltung der Erfindung weist das Schaltelement einen Halbleiterschalter auf, wobei der Halbleiterschalter genau einen Halbleiterbauelementchip aufweist. Der Halbleiterbauelementchip ist das aktive Teil eines Halbleiterschalters. Es umfasst ein Halbleitermaterial, welches den Strom durch den Halbleiterschalter führt. Halbleiterschalter können im Allgemeinen mehrere Halbleiterbauelementchips umfassen, um eine entsprechend hohe Stromtragfähigkeit zu erzielen. Das Schaltelement weist einen Halbleiterschalter und eine dazu antiparallel angeordnete Diode auf, so dass ein Strom durch das Schaltelement in einer Stromrichtung durch den Halbleiterschalter fließt, sofern dieser leitend ist, und in der entgegengesetzten Stromrichtung durch die Diode fließt. Zur Steigerung der Leistungsfähigkeit der Schaltelemente sind die Halbleiterelemente durch mehrere parallele Halbleiterbauelementchips aufgebaut. Dadurch werden die Stromtragfähigkeit und damit die Leistung des Schaltelements vergrößert. Im Hinblick auf eine gute Skalierbarkeit von Stromrichtern, die aus Phasenmodulen aufgebaut sind, hat es sich als sinnvoll erwiesen, dass der Halbleiterschalter genau einen Halbleiterbauelementchip aufweist. Dieser kann bereits auch die Diodenfunktion beinhalten. Alternativ ist es möglich, die Diodenfunktion des Schaltelements durch einen weiteren parallel angeordneten Halbleiterbauelementchip zu realisieren. Mit lediglich einem Halbleiterbauelementchip hat das Schaltelement eine Stromtragfähigkeit im Bereich von 100A bis 200A. Ein Phasenmodul, das Halbleiterschalter und Dioden in einer Anordnung als Halbbrücke aufweist hat damit eine Leistungsfähigkeit im Bereich von 20kW bis 35kW.

Bei der Realisierung des Halbleiterschalters mit genau einem Halbleiterbauelementchip ist der Betrieb des Schaltelements besonders effizient, da es wegen fehlender Parallelschaltung von Halbleiterbauelementchips keine ungleichmäßige Aufteilung des Stroms auf die Halbleiterbauelementchip gibt. Die Ausnutzung des Halbleiterbauelementchips ist daher besonders hoch und die anfallende Verlustleistung vergleichsweise gering, so dass bei der nichtlösbaren Verbindung mit dem Kühlkörper ein besonders kleiner und leichter Kühlkörper zum Einsatz kommen kann. Der Anteil des Gewichts des Kühlkörpers am Gesamtgewicht des Phasenmoduls ist dabei besonders gering. Darüber hinaus eignet sich die Leistungsfähigkeit des Schaltelements im Besonderen dafür, Stromrichter in einem Leistungsbereich von 70kW bis 1MW modular herzustellen.

Bei einer weiteren vorteilhaften Ausgestaltung der Erfindung weist das Phasenmodul zwei Schaltelemente auf, die in einer Reihenschaltung angeordnet sind. Mit diesen zwei Schaltelementen lässt sich auf einfache Weise eine Halbbrücke realisieren. Dieses Phasenmodul weist drei elektrische Anschlüsse auf, wobei zwei zur Verbindung mit einem Zwischenkreiskondensator (gleichspannungsseitige Anschlüsse) vorgesehen sind und ein Anschluss den Phasenanschluss, auch Lastanschluss genannt, bildet. Mit diesen Anschlüssen, entweder nur mit einem oder mehreren dieser Anschlüsse, lässt sich das Phasenmodul im Stromrichter hinreichend beispielsweise an Stromschienen befestigen, so dass keine weiteren mechanischen Befestigungen erforderlich sind.

Damit entsteht durch Integration von Kühlkörper und Halbleitermodul eine komplette Halbbrückeneinheit. Es gibt dabei keine klassische zugängliche Schnittstelle zwischen Modul und Kühlkörper mehr. Das Trägersubstrat wird direkt mit den Kühlkörper (Flüssigkeit als auch Luft) durch z.B. löten, sintern verbunden. Das Phasenmodul inklusive Kühlkörper bildet eine komplette Einheit, die auch im Austauschfall nicht voneinander getrennt wird. Es werden nur ganze Phasenmodule im Fehlerfall ersetzt. Idealerweise ist der Kühlkörper genauso groß (oder nur geringfügig größer) wie das Substrat selbst. Die Kühlung kann auf verschiedenen Prinzipien erfolgen z.B. Luftkühlung und Flüssigkeitskühlung. Ebenso können zusätzliche Elemente für das thermische Management eingesetzt werden wie beispielsweise Wärmespreizer oder Heatpipes.

Bei einer weiteren vorteilhaften Ausgestaltung der Erfindung ist ein Verbindungspunkt der beiden in Reihe angeordneten Schaltelemente mit einem weiteren Schaltelement verbunden, wobei mittels des weiteren Schaltelements ein Strom durch das weitere Schaltelement in beide Fließrichtungen führbar und schaltbar ist. Mit dieser Anordnung ist auf einfache Weise und mit nur wenigen Halbleiterelementen ein 3-Punkt-Stromrichter herstellbar. Mit diesem ist eine genauere Nachbildung einer gewünschten Ausgangsspannung aufgrund höherer Schaltfrequenz und der zusätzlichen Spannungsstufe möglich. Das Phasenmodul stellt damit eine Halbbrücke für einen 3-Punkt-Stromrichter dar.

Bei einer weiteren vorteilhaften Ausgestaltung der Erfindung weist das Phasenmodul zur Ansteuerung des Schaltelements einen Treiber und/oder eine Leistungsendstufe, insbesondere eine Linearendstufe, auf. Der Treiber bzw. die Leistungsendstufe, insbesondere eine Linearendstufe, weist ebenfalls Verluste auf, die in Form von Wärme abgeführt werden muss. Integriert man den Treiber bzw. die Leistungsendstufe bereits in das Phasenmodul, so lässt sich die Wärme mit dem vorhandenen Kühlkörper abführen. Ein weiterer Kühlkörper zur Kühlung der Leistungsendstufe, bei dem die Kühlluft bzw. die Kühlflüssigkeit teilweise aufwendig herangeführt werden muss, kann entfallen.

Dabei erfolgt die Integration des Treibers bzw. der Leistungsendstufe auf das Substrat des Leistungshalbleiters, vorzugsweise in der Ausführung als Linearendstufe. Diese ist vorteilhaft für den flexiblen Einsatz des Phasenmoduls auf verschiedenen Einsatzgebieten. Dabei ist es vorteilhaft, die gleichen Kontaktierungstechnologien wie für die Leistungshalbleiter zu verwenden (Sintern, Löten, Bonden usw.) .

Die Integration des Treibers für die Leistungsendstufte reduziert darüber hinaus die Induktivität im Ansteuerpfad. Hierdurch reduzieren sich die elektrischen Zeitkonstanten und die Steuerbarkeit des Halbleiters, vor allem während des Schaltvorganges (z.B. im Linearbereich), ist teilweise deutlich verbessert.

Trotz der hohen Integration ist das Phasenmodul im Gegensatz zu einer Ausführung mit festen, integrierten Gatewiderständen flexibel einsetzbar, da beispielsweise über die Endstufe das Schaltverhalten auf den Anwendungsfall angepasst werden kann. Dies gilt insbesondere für eine Linearendstufe. Damit kann eine Anpassung des Schaltverhaltens an den entsprechenden Anwendungsfall auf besonders einfache Weise bei dem Stromrichter erfolgen, der mit dieser Art von Phasenmodulen ausgestattet ist.

Bei einer weiteren vorteilhaften Ausgestaltung der Erfindung weist das Phasenmodul eine Messsensorik auf. Insbesondere für die Parallelschaltung von Phasenmodulen hat es sich als vorteilhaft erwiesen, den Strom durch das Phasenmodul zu bestimmen, um eine ungleiche Verteilung von Strömen auf parallel angeordnete Phasenmodule erkennen zu können. Damit ist es möglich, durch geeignete Ansteuerung der Phase Halbleiterschalter einer Fehlverteilung entgegenzuwirken und eine gleichmäßige Aufteilung auf die parallelen Phasenmodule zu erreichen. Eine Messung des Phasenstroms kann in das Phasenmodul mittels Shunt, Hall, GMR integriert werden. Weitere verlustbehaftete Teile der Sensorik für eine Spannungserfassung wie beispielsweise ein Spannungsteiler können ebenfalls in das Phasenmodul mit guter Wärmeleitung zum Kühlkörper integriert werden. Da die Genauigkeit dieser Messvorrichtungen mit höheren Verlusten zunimmt, kann aufgrund der guten thermischen Anbindung höhere Verluste akzeptiert und eine genauere Messwertbestimmung erreicht werden. Die Integration der zusätzlichen Bauelemente ist vorzugsweise auf dem gleichen Substrat des Leistungshalbleiters und ohne gesonderte Bauelementgehäuse ausgeführt. Ebenso ist es vorteilhaft, die gleichen Kontaktierungstechnologien wie für die Leistungshalbleiter zu verwenden (Sintern, Löten, Bonden usw.). Der Spannungsteiler kann dabei rein ohmsch oder ohmsch-kapazitiv ausgeführt sein.

Durch die Integration der verlustbehafteten Elemente auf das Substrat sind diese thermisch gut leitfähig mit der Kühlung verbunden. Hierdurch kann z.B. der Spannungsteiler für die Spannungsmessung niederohmiger ausgeführt werden. Ebenso ist die Sensorik durch den Verguss (oder entsprechendes Material) des Halbleiters vor Verschmutzung und Feuchtigkeit geschützt und somit robuster gegenüber Umgebungseinflüssen. Durch diese Kapselung können zusätzlich die Luft- und Kriechstrecken an den Bauelementen selbst reduziert und damit einhergehend die Packungsdichte erhöht werden. Teilweise kann auf zusätzliche Gehäuse verzichtet werden (z.B. SMD-Gehäuse).

Durch die Integration der Strommessung in das Phasenmodul ist es auf einfache Weise möglich, bei einer Parallelschaltung mehrerer Phasenmodule für eine Phase die Stromaufteilung auf die einzelnen Phasenmodule der Stromrichterphase zu regeln. Durch entsprechende Ansteuersignale, beispielsweise durch Verzögerung von Ansteuersignalen, ist es möglich, die Stromaufteilung derart zu beeinflussen, dass alle Phasenmodule einer Stromrichterphase von einem Strom gleicher Größe durchflossen werden. Somit lässt sich der Stromrichter bestmöglich in Bezug auf seine Leistungsfähigkeit ausnutzen.

Bei einer weiteren vorteilhaften Ausgestaltung der Erfindung weist der Stromrichter eine Vielzahl von Phasenmodulen auf, wobei die Phasenmodule in einer Parallelschaltung angeordnet sind. Mit Hilfe des Phasenmoduls lassen sich modular aufgebaute Stromrichter herstellen. Bei der Verwendung von Schaltelementen mit einer Sperrspannung im Bereich von 1200V bis 1700V und darüber hinaus lassen sich beispielsweise 2-Punkt-Stromrichter in einem Leistungsbereich von ca. 70kW bis 1MW herstellen. Diesen Stromrichtern ist gemeinsam, dass diese die gleichen Phasenmodule aufweisen. Die Skalierung wird durch die Anzahl parallel angeordneter Phasenmodule vorgenommen. Gerade für Hersteller von Stromrichtern ist die Verwendung von möglichst vielen Gleichteilen im Stromrichter von hoher Bedeutung. Dadurch lassen sich Wettbewerbsvorteile aufgrund hoher Stückzahlen erzielen. Darüber hinaus ist die Ersatzteilhaltung aufgrund weniger unterschiedlicher Teile kostengünstig realisierbar. Dies gilt insbesondere für Phasenmodule, da diese Halbleiterschalter in Form von Leistungshalbleitern aufweisen, die eine hohe Auswirkung auf die Kosten eines Stromrichters haben. Drei der Phasenmodule bilden die kleinste modulare Einheit eines dreiphasigen Stromrichters. Dies können dann beispielsweise in einer Rahmenkonstruktion des Stromrichters angeordnet werden.

Bei einer weiteren vorteilhaften Ausgestaltung der Erfindung weist das Phasenmodul mindestens einen elektrischen Anschluss auf und ist mittels des mindestens eines elektrischen Anschlusses im Stromrichter befestigt. Durch die gute thermische Anbindung der Leistungshalbleiter an den Kühlkörper des Phasenmoduls ist der Aufbau des Phasenmoduls derart leicht, dass das Phasenmodul mechanisch an den elektrischen Anschlüssen im Stromrichter befestigt werden kann. Dazu eigenen sich insbesondere Stromschienen aus Kupfer, die gleichzeitig der elektrischen Verbindung der Phasenmodule dienen. Die Querschnittsfläche der Stromschienen bestimmt sich unter anderem aus der Leistungsfähigkeit des daran angeschlossenen Phasenmoduls bzw. der daran angeschlossenen Phasenmodule. Es hat sich gezeigt, dass diese durch den relativ gewichtsarmen Aufbau der Phasenmodule geeignet sind, das gesamte Gewicht der Phasenmodule sowie darüber hinausgehende Kräfte aufgrund von Beschleunigungen, Erschütterungen oder Vibrationen aufzunehmen.

Besonders vorteilhaft ist die mechanische Befestigung für Phasenmodule, die als Halbbrücke für einen 2-Punkt-Stromrichter ausgeführt sind. Hier sind zwei Gleichspannungsanschlüsse für die Kontaktierung mit einem Zwischenkreiskondensator vorhanden, die vorzugsweise niederinduktiv ausgeführt werden und gleichzeitig als mechanische Befestigung für das Phasenmodul dienen können. Bei der Ausführung als 3-Punkt-Stromrichter stehen sogar drei Gleichspannungsanschlüsse zur Kontaktierung mit Zwischenkreiskondensatoren zur Verfügung, die ebenfalls vorzugsweise niederinduktiv und daher mit Stromschiene kontaktiert werden. Dieser elektrische Kontakt kann neben der Stromführung auch bei dem 3-Punkt Stromrichter gleichzeitig die Aufgabe der Befestigung im Stromrichter übernehmen.

Im Folgenden wird die Erfindung anhand der in den Figuren dargestellten Ausführungsbeispiele näher beschrieben und erläutert. Dabei zeigen:
- FIG 1, FIG 2: den Schnitt durch ein Phasenmodul,
- FIG 3: den inneren Aufbau eines Phasenmoduls,
- FIG 4, FIG 5: den Aufbau einer Halbbrücke,
- FIG 6: die Befestigung von Phasenmodulen im Stromrichter und
- FIG 7: eine Halteplatte für Phasenmodule.

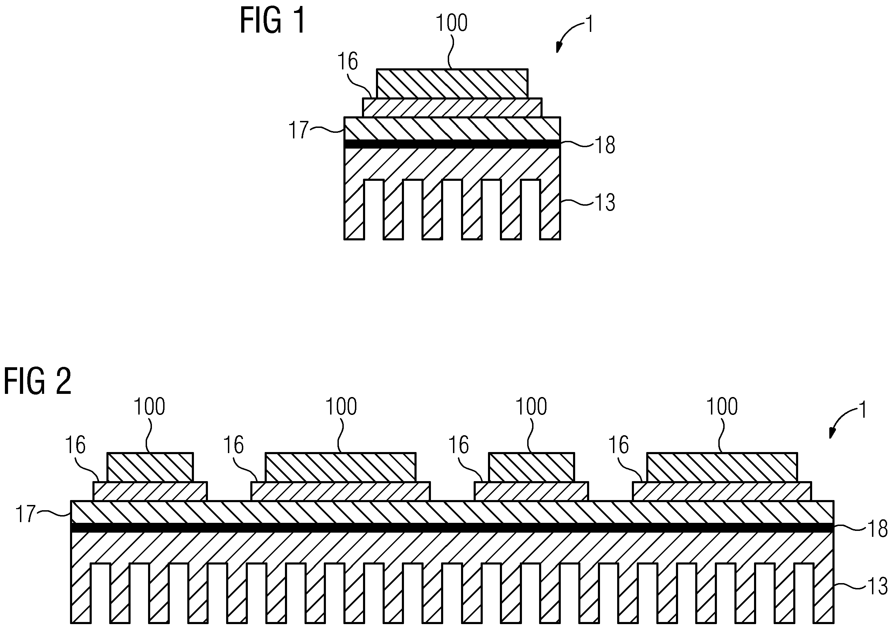

FIG 1 zeigt den Schnitt durch ein Phasenmodul 1. Hierbei ist der Halbleiterbauelementchip 100 mit dem Kühlkörper 13 verbunden. Zur elektrischen Kontaktierung des Halbleiterbauelementchips 100 dient die Kupferschicht 16. Eine zweite Kontaktierung des Halbleiterbauelementchips 100 ist der Einfachheit halber in dieser Figur nicht dargestellt. Die Kupferschicht 16 ist dabei auf einem Substrat 18, auch als Trägerschicht bezeichnet, aufgetragen. Diese bildet das Schaltelement 10. Mithilfe einer Verbindungsschicht, wie beispielsweise Lot oder Klebeschicht, wird eine nichtlösbare Verbindung zum Kühlkörper 13 hergestellt.

Das hier dargestellte Phasenmodul 1 umfasst in der hier dargestellten einfachen Ausführungsform genau einen Halbleiterbauelementchip 100. Dieser Halbleiterbauelementchip 100 kann dabei sowohl die Funktion des Halbleiterschalters 11 als auch die Funktion der Diode 12 umfassen. Alternativ ist es möglich, diese beiden Funktionen durch separate Halbleiterbauelementchip 100 zu realisieren.

FIG 2 zeigt den Schnitt durch ein weiteres Phasenmodul 1. Zur Vermeidung von Wiederholungen wird auf die Beschreibung zur FIG 1 sowie auf die dort eingeführten Bezugszeichen verwiesen. Dieses Phasenmodul 1 weist vier Halbleiterbauelementchips 100 auf, die sich in ihrer Größe unterscheiden. Dabei stellen die größeren Halbleiterbauelementchips 100 die Funktion des Halbleiterschalters 11 und die kleineren Halbleiterbauelementchips 100 die Funktion der Diode 12 her. Zur elektrischen Kontaktierung dienen die Kupferschichten 16. Auch hier wurde auf die Darstellung der zweiten Kontaktierung der einzelnen Halbleiterbauelementchips 100 verzichtet. Die einzelnen Kupferschichten 16 sind wiederum auf das Substrat 18 aufgetragen. Die Verbindungsschicht 18 dient dazu, eine nichtlösbare Verbindung zwischen den Schaltelementen 10 und dem Kühlkörper 13 zu schaffen. Bei der Verbindungsschicht 18 kann es sich beispielsweise um Lot oder eine Klebeschicht handeln. Mit diesen vier Halbleiterbauelementchips 100 kann auf einfache Weise eine Halbbrücke für einen 2-Punkt-Stromrichter aufgebaut werden.

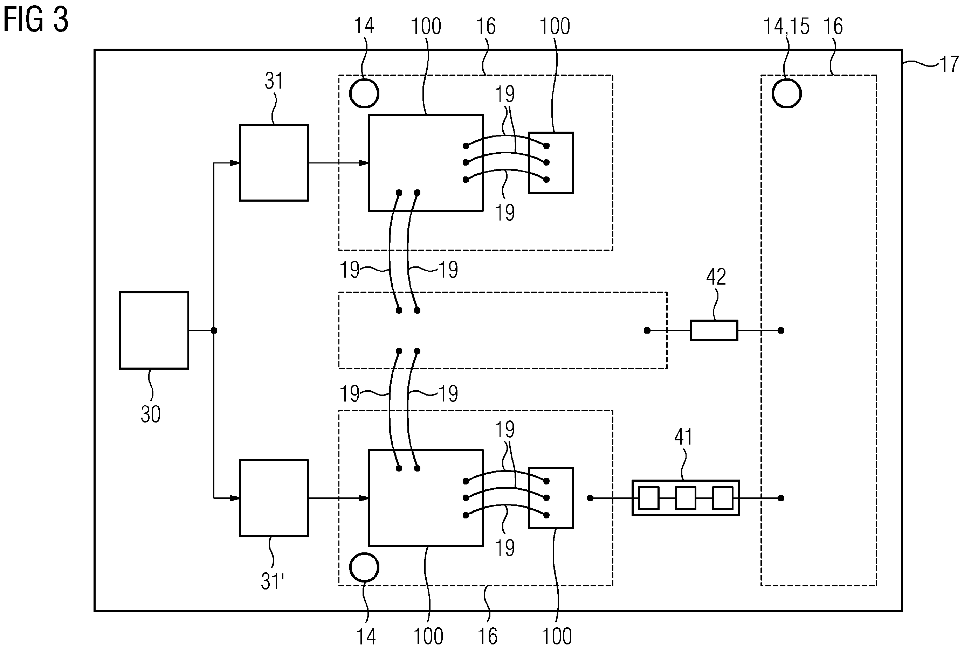

FIG 3 zeigt den inneren Aufbau eines Phasenmoduls 1 in der Aufsicht. Man erkennt das Substrat 17 welches die einzelnen Komponenten des Phasenmoduls 1 trägt. Die Leistungshalbleiterelemente sind dabei die Halbleiterbauelementchips 100. Diese sind auf Kupferschichten 16 angeordnet. Die zweite Kontaktierung, beispielsweise zwischen den Halbleiterbauelementchip 100 oder zwischen Halbleiterbauelementchip 100 und Kupferschicht 16 erfolgt mittels Bonddraht 19. Die Kupferschichten 16, auf denen ein Halbleiterbauelementchip 100 angebracht ist, weisen darüber hinaus einen elektrischen Anschluss 14 auf. Der Lastanschluss 15 ist ebenfalls mit einer Kupferschicht 16 verbunden. In der elektrischen Verbindung zwischen Halbleiterbauelementchip 100 und Lastanschluss 15 ist ein Shunt 42 angeordnet, mit dem sich der Ausgangsstrom bestimmen lässt. Zur Bestimmung der Spannung am Lastanschluss 15 dient der Spannungsteiler 41. Dieser ist zwischen den Kupferschichten 16 des Lastanschlusses 15 und eines Halbleiterbauelementchips 100 angeordnet. Zur Ansteuerung der Halbleiterbauelementchips 100 der Halbleiterschalter 10 dienen die Leistungsendstufen 31. Diese stellen am Steueranschluss des Schaltelements 10 eine für den Betrieb erforderliche Steuerspannung (Gatespannung) bereit. Mithilfe einer linearen Leistungsendstufe 31 ist es möglich, die Spannung am Steueranschluss einstellbar zu gestalten. Damit kann das Schaltverhalten des Schaltelements 10 an den Anwendungsfall angepasst werden. Die Leistungsendstufen 31 erhalten vom Treiber 30 die Information, welchen Schaltzustand die Schaltelemente 10 annehmen sollen. Ebenso ist es möglich eine gewünschte Spannung für den Steueranschluss an die Leistungsstufe 31 zu übertragen. Dabei enthält der Treiber 30 die Intelligenz, die für die Ansteuerung der Halbleiterschalter 11 erforderlich ist, wie beispielsweise eine Spannungsüberwachung.

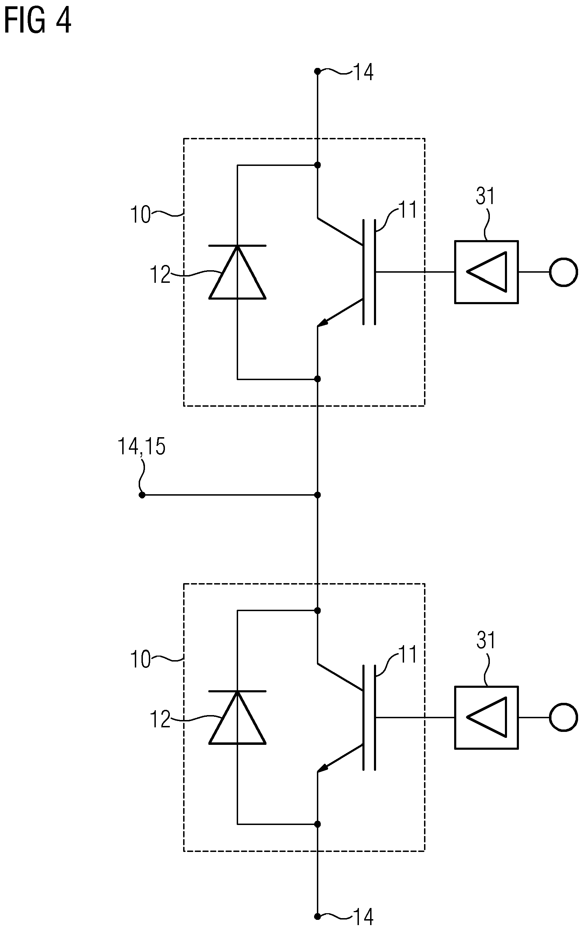

FIG 4 zeigt den Aufbau eines Phasenmoduls 1 mit zwei Schaltelementen 10, die in einer Reihenschaltung angeordnet sind und damit eine Halbbrücke bilden. Der Verbindungspunkt zwischen beiden Schaltelementen 10 bildet den Lastanschluss 15. Die verbleibenden elektrischen Anschlüsse 14 bilden den Anschluss an den Zwischenkreis. Die Schaltelemente 10 umfassen einen Halbleiterschalter 11 und eine dazu antiparallel angeordnete Diode 12. Der Halbleiter Schalter 11 wird über die Leistung Endstufe 31 angesteuert und in seine Betriebszustände "Leiten" oder "Sperren" versetzt. Mit dieser Ausführungsform lässt sich auf einfache Weise ein 2-Punkt-Stromrichter realisieren.

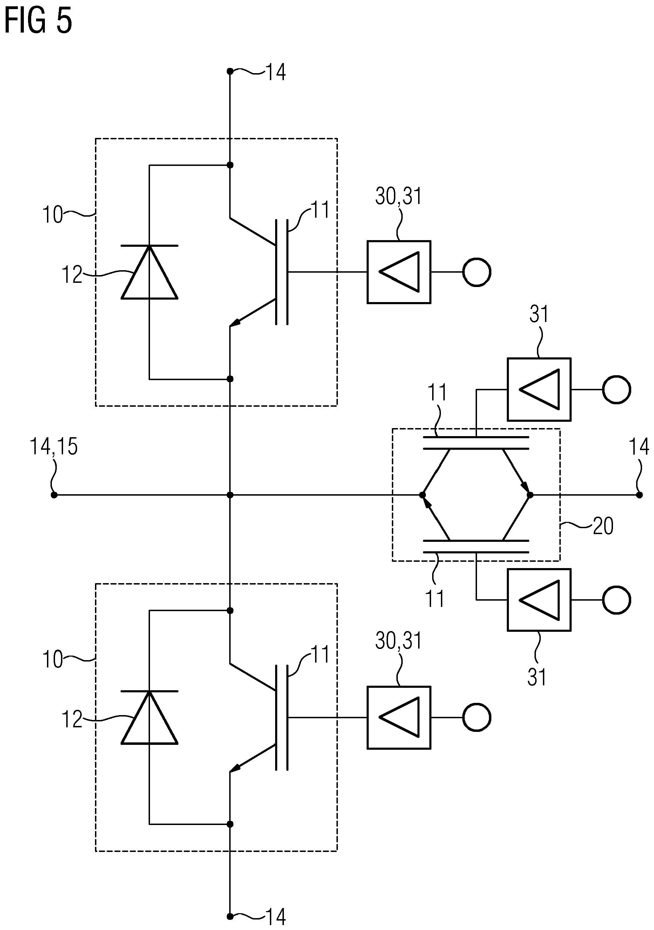

FIG 5 zeigt den Aufbau eines anderen Phasenmoduls 1 zur Herstellung eines 3-Punkt-Stromrichters. Zur Vermeidung von Wiederholungen wird auf die Beschreibung zu FIG 4 sowie auf die dort eingeführten Bezugszeichen verwiesen. Ergänzend zum Aufbau einer Halbbrücke für 2-Punkt-Stromrichter wird am Verbindungspunkt zwischen den beiden Schaltelementen 10 ein weiteres Schaltelement 20 hinzugefügt. Gleichspannungsseitig stehen nun drei elektrische Anschlüsse 14 zur Verfügung. Der Lastanschluss 15 kann nun eines der drei Potenziale der Gleichspannungsseite annehmen. Auch die Halbleiterschalter 11 des weiteren Schaltmoduls 20 werden über Leistungsendstufen 31 angesteuert.

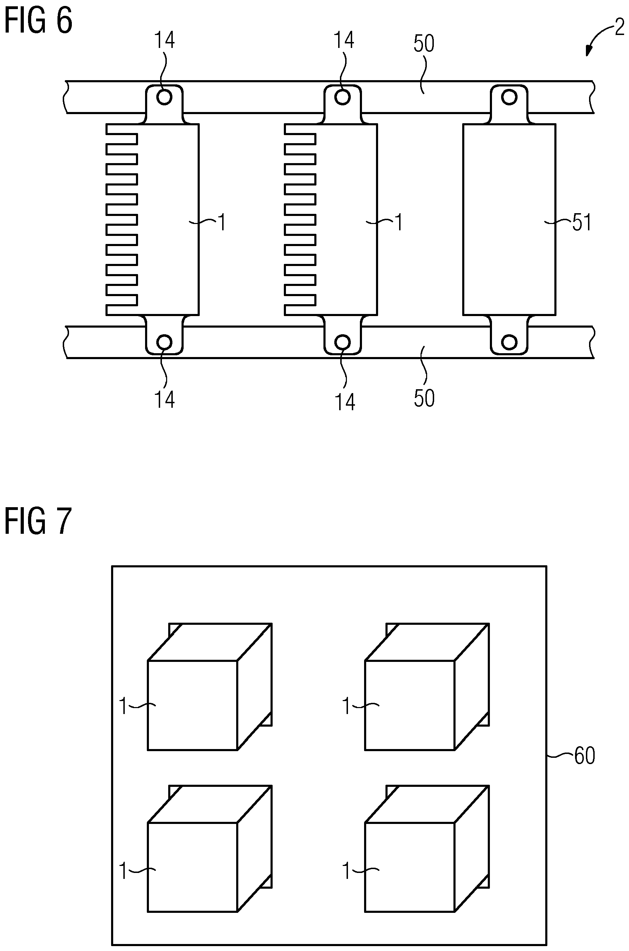

FIG 6 zeigt einen Stromrichter 2 mit zwei Phasenmodulen 1 und einem Kondensator 51. Die elektrischen Anschlüsse 14 sind über Stromschienen 50 elektrisch mit dem Kondensator 51 verbunden. Dabei sind die Stromschienen 50 am Stromrichter 2 befestigt. Die mechanische Befestigung der Phasenmodule 1 erfolgt über die elektrischen Anschlüsse 14. Eine zusätzliche mechanische Befestigung der Phasenmodule 1 ist nicht erforderlich.

Bei dem hier dargestellten Stromrichter 2 handelt es sich um einen einphasigen Stromrichter 2. Zur Realisierung eines dreiphasigen Stromrichters 2 ist ein weiteres Phasenmodul 1, also insgesamt drei Phasenmodule 1, erforderlich. Um die Leistungsfähigkeit eines Stromrichters 2 zu erhöhen werden darüber hinaus weitere Phasenmodule 1 im Stromrichter 2 angeordnet. Dabei werden die Lastanschlüsse 15, hier nicht dargestellt, einer Phase ebenfalls miteinander verbunden.

Eine weitere Möglichkeit der Anordnung von Phasenmodulen 1 in einem Stromrichter 2 zeigt FIG 7. Dabei werden die einzelnen Phasenmodule 1 in eine Halteplatte 60 gesteckt. Die Halteplatte 60 hat dabei schablonenartige Öffnungen, in denen die Phasenmodule 1 angeordnet werden. Aufgrund des geringen Gewichtes der Phasenmodule 1 können diese auf einfache Weise, beispielsweise durch eine Klemmverbindung, in der Halteplatte 60 gehalten werden.

Obwohl die Erfindung im Detail durch die bevorzugten Ausführungsbeispiele näher illustriert und beschrieben wurde, ist die Erfindung nicht alleine auf die offenbarten Beispiele beschränkt und andere Variationen können vom Fachmann hieraus abgeleitet werden, ohne den Schutzumfang der Erfindung zu verlassen.

Zusammenfassend betrifft die Erfindung ein Phasenmodul für einen Stromrichter aufweisend mindestens ein Schaltelement und einen Kühlkörper. Zur Verbesserung der Kühleigenschaft eines Phasenmoduls wird vorgeschlagen, dass das Schaltelement mit dem Kühlkörper verbunden ist, wobei die Verbindung zwischen Schaltelement und Kühlkörper eine nichtlösbare Verbindung ist. Die Erfindung betrifft weiter einen Stromrichter mit mindestens einem solchen Phasenmodul sowie ein Verfahren zur Herstellung eines derartigen Phasenmoduls, wobei zur Herstellung einer Verbindung zwischen dem Schaltelement und dem Kühlkörper das Schaltelement auf den Kühlkörper gelötet, gesintert oder geklebt wird.

## Patentansprüche

1. Stromrichter (2) mit mindestens einem Phasenmodul (1), wobei das Phasenmodul (1)
- mindestens ein Schaltelement (10) mit einer Sperrspannung im Bereich von 1200 V bis 1700 V und
- einen Kühlkörper (13) aufweist
wobei das Schaltelement (10) mit dem Kühlkörper (13) verbunden ist, wobei die Verbindung zwischen Schaltelement (10) und Kühlkörper (13) eine nichtlösbare Verbindung ist, die gelötet, gesintert oder geklebt ausgeführt ist, wobei das Phasenmodul (1) mindestens einen elektrischen Anschluss (14) aufweist, **dadurch gekennzeichnet, dass** das Phasenmodul (1) mittels des elektrischen Anschlusses (14) an einer Stromschiene ohne zusätzliche mechanische Fixierung im Stromrichter (2) befestigt ist.

2. Stromrichter (2) nach Anspruch 1, wobei der Stromrichter (2) eine Vielzahl von Phasenmodulen (1) aufweist, wobei die Phasenmodule (1) in einer Parallelschaltung angeordnet sind.

3. Stromrichter (1) nach einem der Ansprüche 1 oder 2, wobei das Gewicht des Kühlkörpers (13) weniger als 50% des Gewichts des gesamten Phasenmoduls (1) inklusive Kühlkörper (13) beträgt.

4. Verfahren zur Herstellung eines Stromrichters (2) nach einem der Ansprüche 1 bis 3, wobei zur Herstellung einer Verbindung zwischen dem Schaltelement (10) und dem Kühlkörper (13) das Schaltelement (10) auf den Kühlkörper (13) gelötet, gesintert oder geklebt wird.

5. Verfahren nach Anspruch 4, wobei das Phasenmodul (1) eine Sperrspannung im Bereich von 1200 V bis 1700 V aufweist, wobei beim Löten oder Sintern die Kontaktfläche sowohl des Schaltelements (10) als auch des Kühlkörpers (13) gleichmäßig erwärmt wird.

## Claims

1. Power converter (2) with at least one phase module (1), wherein the phase module (1) has
- at least one switching element (10) with a cut-off voltage ranging from 1200V to 1700V and
- a heat sink (13)
wherein the switching element (10) is connected to the heat sink (13), wherein the connection between switching element (10) and heat sink (13) is a non-detachable connection, which is embodied soldered, sintered or glued, wherein the phase module (1) has at least one electrical terminal (14), **characterised in that** the phase module (1) is fastened to a busbar in the power converter (2) by means of the electrical terminal (14) without additional mechanical fixing.

2. Power converter (2) according to claim 1, wherein the power converter (2) has a plurality of phase modules (1), wherein the phase modules (1) are arranged in a parallel circuit.

3. Power converter (1) according to one of claims 1 or 2, wherein the weight of the heat sink (13) amounts to less than 50% of the weight of the phase module (1) as a whole, including heat sink (13).

4. Method for producing a power converter (2) according to one of claims 1 to 3, wherein to produce a connection between the switching element (10) and the heat sink (13), the switching element (10) is soldered, sintered or glued onto the heat sink (13) .

5. Method according to claim 4, wherein the phase module (1) has a cut-off voltage ranging from 1200V to 1700V, wherein, during soldering or sintering, the contact surface of both the switching element (10) and also the heat sink (13) is heated up evenly.

## Revendications

1. Convertisseur (2), comprenant au moins un module (1) de phase, le module (1) de phase ayant
- au moins un élément (10) de coupure ayant une tension de blocage dans la plage de 1 200 V à 1 700 V et
- un puits de chaleur (13)
l'élément (10) de coupure étant relié au puits de chaleur (13), la liaison entre l'élément (10) de coupure et le puits de chaleur (13) étant une liaison inamovible, qui est réalisée brasée, frittée ou collée, le module (1) de phase ayant au moins une borne (14) électrique, **caractérisé en ce que** le module (1) de phase est fixé, au moyen de la borne (14) électrique, à une barre de courant, sans immobilisation mécanique supplémentaire dans le convertisseur (2).

2. Convertisseur (2) suivant la revendication 1, dans lequel le convertisseur (2) a une pluralité de modules (1) de phase, les modules (1) de phase étant montés suivant un circuit en parallèle.

3. Convertisseur (2) suivant la revendication 1 ou 2, dans lequel le poids du puits de chaleur (13) représente moins de 50% du poids de tout le module (1) de phase, y compris le puits de chaleur (13).

4. Procédé de fabrication d'un convertisseur (2) suivant l'une des revendications 1 à 3, dans lequel, pour produire une liaison entre l'élément (10) de coupure et le puits de chaleur (13), on brase, on fritte ou on colle l'élément (10) de coupure au puits (13) de chaleur.

5. Procédé suivant la revendication 4, dans lequel le module (1) de phase a une tension de blocage dans la plage de 1 200 V à 1 700 V , dans lequel, lors du brasage ou du frittage, on échauffe uniformément les surfaces de contact, tant de l'élément (10) de coupure qu'également du puits de chaleur (13).
